(19) 

Europäisches
Patentamt
European
Patent Office
Office européen
des brevets

(11)  **EP 4 607 339 A1**

(12) **EUROPEAN PATENT APPLICATION**
published in accordance with Art. 153(4) EPC

(43) Date of publication:
**27.08.2025  Bulletin 2025/35**

(21) Application number: **23928274.2**

(22) Date of filing: **25.08.2023**

(51) International Patent Classification (IPC):
**G06F 8/41** *(2018.01)*

(52) Cooperative Patent Classification (CPC):
Y02D 30/70

(86) International application number:
**PCT/CN2023/114955**

(87) International publication number:
**WO 2024/192969 (26.09.2024 Gazette 2024/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **20.03.2023  CN 202310299035**

(71) Applicants:
• **China Nuclear Power Engineering Co., Ltd.
 Shenzhen, Guangdong 518124 (CN)**
• **China Nuclear Power Design Company Ltd.
 (Shenzhen)
 Shenzhen, Guangdong 518172 (CN)**

(72) Inventors:
• **WANG, Peng
 Shenzhen, Guangdong 518172 (CN)**

• **WANG, Yunfu
 Shenzhen, Guangdong 518172 (CN)**
• **HOU, Bin
 Shenzhen, Guangdong 518172 (CN)**
• **CHEN, Weihua
 Shenzhen, Guangdong 518172 (CN)**
• **LUO, Yalin
 Shenzhen, Guangdong 518172 (CN)**
• **PENG, Jin
 Shenzhen, Guangdong 518172 (CN)**
• **DU, Liqiong
 Shenzhen, Guangdong 518172 (CN)**
• **LEI, Weijian
 Shenzhen, Guangdong 518172 (CN)**
• **MU, Senhui
 Shenzhen, Guangdong 518172 (CN)**

(74) Representative: **V.O.
 P.O. Box 87930
 2508 DH Den Haag (NL)**

(54) **ENCODING METHOD AND APPARATUS, COMPUTER DEVICE, AND STORAGE MEDIUM**

(57)    The present application relates to the technical field of data processing, and in particular to an encoding method and apparatus, a computer device, and a storage medium. The method comprises: acquiring a node index corresponding to a child node to be encoded; determining the node index as a variable value of a Mobius transformation function; and on the basis of a coefficient of the Mobius transformation function and the variable value corresponding to the node index, obtaining an encoding interval corresponding to said child node, wherein the coefficient of the Mobius transformation function is obtained by adjusting a parent interval endpoint value corresponding to the parent node of said child node. The method provided by the present application facilitates construction of an element tree of a device.

| | |
|---|---|
| a node index corresponding to a to-be-encoded child node is acquired | S101 |
| the node index is determined as a variable value of the Mobius transformation function | S102 |
| an encoding interval corresponding to the to-be-encoded child node is obtained based on the coefficient values of the Mobius transformation function and the variable value corresponding to the node index | S103 |

FIG. 1

**Description**

**CROSS-REFERENCE TO RELATED APPLICATION**

The present application claims priority to Chinese Patent Application with No. 202310299035.9, entitled "Encoding Method and Apparatus, Computer Device, and Storage Medium", and filed on March 20, 2023, the content of which is expressly incorporated herein by reference in its entirety.

**TECHNICAL FIELD**

The present application relates to the field of data processing technology, particularly to an encoding method and apparatus, a computer device, and a storage medium.

**BACKGROUND**

A component tree of a nuclear power equipment is a tree structure for describing components and a hierarchical relationship between the components of a large-scale nuclear power equipment. A root node is usually formed by a large-scale equipment body, and the equipment body is deconstructed and decomposed layer by layer to form a component tree of the whole equipment. This is a typical infinite hierarchical tree structure. Generally, there are two tree structure models to deal with the infinite hierarchical nonlinear relationship, that is, a hierarchical recursive model and a tree encoding model.

The tree encoding model encodes and indexes tree nodes by means of an algorithm, so that the query time of the node is shortened and the query complexity is reduced. For example, an improved preorder traversal tree model encodes one tree node with only a pair of ordered positive integers called left and right values, and an ancestral-descendant relationship is reflected by a subset relationship between integer intervals, which provides a very intuitive basis for the hierarchical query.

However, encoding with left and right values of a node is performed by using integers in the conventional technology, the number of child nodes that each node can receive is limited, which is not conducive to the construction of the component tree.

**SUMMARY**

In view of this, as for the above technical problem, it is necessary to provide an encoding method and apparatus, a computer device and a storage medium which are beneficial to construct the component tree.

In the first aspect of the present application, an encoding method is provided, which may include:

acquiring a node index corresponding to a to-be-encoded child node;
determining the node index as a variable value of a Mobius transformation function; and
obtaining an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

In an embodiment, the adjusting the endpoint values of the parent interval corresponding to the parent node of the to-be-encoded child node may include:

adjusting the endpoint values of the parent interval corresponding to the parent node of the to-be-encoded child node based on scaling factors, and obtaining the coefficient values of the Mobius transformation function.

In an embodiment, the determining the node index as the variable value of the Mobius transformation function may include:

transforming the node index based on an encoding type selection function to obtain a transformed index, in which the encoding type selection function is a monotone function of node indexes in the parent interval; and
determining the transformed index as the variable value of the Mobius transformation function.

In an embodiment, the encoding type selection function is a linear function or an exponential function.

In an embodiment, the node index may include a left sub-index and a right sub-index, the obtaining the encoding interval corresponding to the to-be-encoded child node based on the coefficient values of the Mobius transformation function and the variable value corresponding to the node index may include:

determining a left encoded value based on the left sub-index and the coefficient values of the Mobius transformation function;

determining a right encoded value based on the right sub-index and the coefficient values of the Mobius transformation function; and

determining the encoding interval corresponding to the to-be-encoded child node based on the left encoded value and the right encoded value.

In an embodiment, the method may further include:

for an encoding interval, determining and storing a mapping relationship between the encoding interval and a parent interval corresponding to the encoding interval;

the mapping relationship is configured to, when a query instruction corresponding to the parent interval is acquired, determine the parent interval corresponding to the encoding interval according to the encoding interval.

In the second aspect of the present application, an encoding apparatus is provided, which may include:

an acquisition module, configured to acquire a node index corresponding to a to-be-encoded child node;

an assignment module, configured to determine the node index as a variable value of the Mobius transformation function; and

a determination module, configured to obtain an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

In the third aspect of the present application, a computer device is provided, which may include a processor and a memory storing a computer program, the processor, when executing the computer program, may implement the following steps of:

acquiring a node index corresponding to a to-be-encoded child node;

determining the node index as a variable value of a Mobius transformation function; and

obtaining an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

In the fourth aspect of the present application, a computer-readable storage medium is provided, on which a computer program is stored, the computer program, when executed by a processor, may cause the processor to implement the following steps of:

acquiring a node index corresponding to a to-be-encoded child node;

determining the node index as a variable value of a Mobius transformation function; and

obtaining an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

In the fifth aspect of the present application, a computer program product is provided, which may include a computer program, the computer program, when executed by a processor, may cause the processor to implement the following steps of:

acquiring a node index corresponding to a to-be-encoded child node;

determining the node index as a variable value of a Mobius transformation function; and

obtaining an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

## BRIEF DESCRIPTION OF THE DRAWINGS

In order to describe the technical solution in the embodiments of the present invention or the prior art more clearly, accompanying drawings required for describing the embodiments or the prior art will be briefly introduced below. Obviously, the accompanying drawings in the following description show merely some embodiments of the present invention, and a person of ordinary skill in the art may still obtain other drawings from these accompanying drawings without any creative effort.

FIG. 1 is a flow chart showing an encoding method according to an embodiment.
FIG. 2 is a flow chart of determining an encoding interval of a to-be-encoded child node according to an embodiment.
FIG. 3 is a flow chart of determining a variable value based on an encoding type selection function according to an embodiment.
FIG. 4 is a flow chart showing an encoding method according to another embodiment.
FIG. 5 is a schematic structure diagram of an encoding apparatus according to an embodiment.
FIG. 6 is an internal structure diagram of a computer device according to an embodiment.

## DETAILED DESCRIPTION

In order to make the purpose, the technical solution, and advantages of the present invention clearer to understand, the present invention is elaborated below in conjunction with the accompanying drawings and embodiments. It should be appreciated that the specific embodiments described herein are merely used for explaining the present invention, not to limit the present application.

In an embodiment of the present invention, an encoding method is provided, which can be applied to a data processing scenario, and specifically can be applied to a component tree construction scenario. Optionally, the method may be executed by a computer device, and the computer device may be a server.

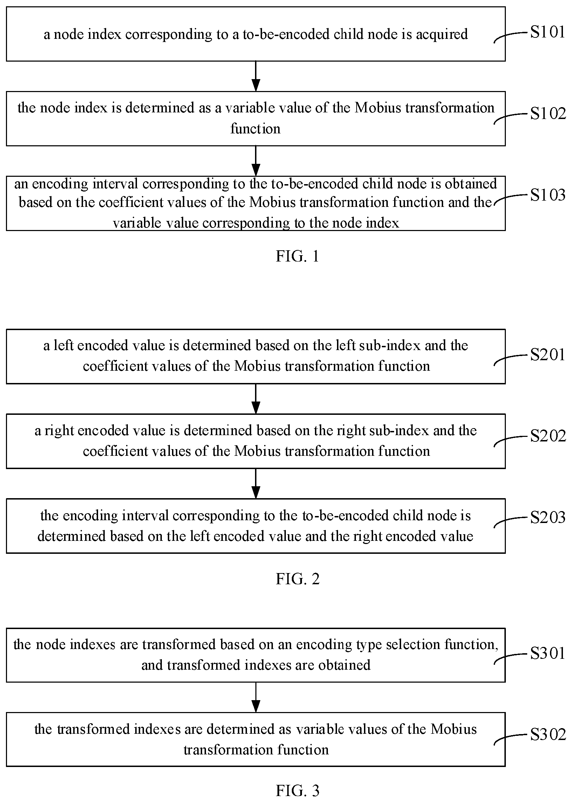

In an embodiment, as shown in FIG. 1, an encoding method is provided, which may include the following steps.

S101: a node index corresponding to a to-be-encoded child node is acquired.

In the component tree of the nuclear power equipment, each node is configured to represent a device or a component corresponding to the device. A node type may include a root node and a child node. The child node is a component forming the root node (device). It should be appreciated that, in the component tree of the nuclear power equipment, a node index of each node refers to a unique identifier of the node, such as an ID. For example, the node index corresponding to the first node is 1 (or A), the node index corresponding to the second node is 2 (or B), and the node index corresponding to the third node is 3 (or C), and so on.

Further, in order to represent a hierarchical relationship between the nodes, and facilitate adding and deleting a node, each node in the component tree in the embodiment is configured with two attributes: a node index and an encoding interval. As shown in the foregoing example, when there exists a parent-child relationship between two nodes, a nested relationship exists between the encoding intervals of the two nodes. Therefore, the component tree is generated based on the nested relationships of the encoding intervals among the nodes. In this case, the to-be-encoded child node refers to a node in the component tree for which an encoding interval is to be generated.

S102: the node index is determined as a variable value of the Mobius transformation function.

The Mobius transformation function is expressed as the following formula (1):

$$f(x) = \frac{ax+b}{cx+d} \tag{1}$$

where $a$, $b$, $c$, and $d$ are coefficient values in the Mobius transformation function, and $x$ is a variable value in the Mobius transformation function.

S103: an encoding interval corresponding to the to-be-encoded child node is obtained based on the coefficient values of the Mobius transformation function and the variable value corresponding to the node index.

Further, when $bc - ad > 0$, and $x \in [1, +\infty]$, a range of values of the Mobius transformation function is expressed as the following formula (2):

$$\frac{a}{c} \le f(x) = \frac{ax+b}{cx+d} \le \frac{a+b}{c+d} \tag{2}$$

The coefficient values of the Mobius transformation function are obtained by adjusting endpoint values of a parent interval corresponding to a parent node of the to-be-encoded child node.

In the formula (2), it is assumed that *a, c, a+b, c+d* are all greater than 0.

Let *a*=lft_num, *c*=lft_den, *a+b*=rgt_num, and *c+d*=rgt_den. The Lft_num, and lft_den respectively represent a numerator and a denominator of a left boundary of an encoding interval corresponding to the parent node. The Rgt_num and rgt_den respectively represent a numerator and a denominator of a right boundary of the encoding interval. These coefficient values are substituted into the above formula (2), and the following formula (3) is obtained after transformation:

$$\frac{lft\_num}{lft\_den} \leq f(x) = \frac{lft\_num * x + (rgt\_num - lft\_num)}{lft\_den * x + (rgt\_den - lft\_den)} \leq \frac{rgt\_num}{rgt\_den} \qquad (3)$$

It should be learned from the formula (3) that, after the encoding interval $\left[\frac{lft\_num}{lft\_den}, \frac{rgt\_num}{rgt\_den}\right]$ corresponding to the parent node to which the to-be-encoded child node belongs is determined, the coefficient values *a, b, c,* and *d* in the Mobius transformation function are determined. After that, the node index ($x$) of the to-be-encoded child node is determined, and the node index ($x$) is substituted into $f(x)$ in the above formula (3), to obtain a value of $f(x)$, i.e., serving as an encoded value of the node index ($x$).

It should be appreciated that, in order to generate the encoding interval of the node index, in an implementable mode, the node index of each to-be-encoded child node may be a node index interval, for example, [x1, x2]. In this case, the encoding interval corresponding to the node index can be obtained based on the above formula (3). In another implementable mode, the node index of each to-be-encoded child node may be a single value, for example, $x$. In this case, the encoded value corresponding to the node index can be obtained based on the above formula (3), and the encoded value is further transformed to generate the encoding interval.

In the above encoding method, after the encoding interval of the parent node is acquired, the coefficient values of the Mobius transformation function are obtained based on the encoding interval of the parent node, that is, the encoding interval of the parent node is a rational number interval. For any to-be-encoded child node under the parent node, the node index corresponding to the to-be-encoded child node is determined as a variable value of the Mobius transformation function, and is substituted into the Mobius transformation function to obtain a function value of the Mobius transformation function. The function value serves as an encoding interval of the to-be-encoded child node, so that the encoding interval of the to-be-encoded child node falls into the encoding interval of the parent node, and an encoding interval having a hierarchical relationship corresponding to the parent-child nodes is generated. Further, node indexes corresponding to different to-be-encoded child nodes are different, so that encoding intervals of different to-be-encoded child nodes are independent of each other, and there is no need to modify encoding intervals of other to-be-encoded child nodes when a new node is added, thereby avoiding variation of node encoding. In addition, the encoding interval of the to-be-encoded child node generated based on the Mobius transformation function is a rational number interval. Accordingly, since the number of rational numbers in the rational number interval within the encoding interval of the to-be-encoded child node is infinite, it is ensured that a capacity of nodes in the rational number interval is infinite, that is, infinite child nodes can be inserted into the rational number interval. Correspondingly, encoding intervals of infinite lower-level nodes can be regenerated in the encoding interval of the to-be-encoded child node. Compared to the conventional technology, the problem of limited capacity of nodes in the component tree is addressed.

As shown in FIG. 2, the embodiment provides an optional mode of obtaining an encoding interval corresponding to a to-be-encoded child node based on coefficient values of the Mobius transformation function and the variable value corresponding to the node index, that is, provides a mode of detailing S103. The node index may include a left sub-index and a right sub-index. Optionally, both the left sub-index and the right sub-index in the embodiment are natural numbers.

S201: a left encoded value is determined based on the left sub-index and the coefficient values of the Mobius transformation function.

Specifically, for any child node of the parent node, if the node indexes corresponding to the child node are *x1* and *x2* (and *x2>x1*), *x1* serves as a variable value of the Mobius transformation function, and is substituted into the Mobius transformation function to obtain a left encoded value $f(x1)$.

S202: a right encoded value is determined based on the right sub-index and the coefficient values of the Mobius transformation function.

Further, *x2* serves as a variable value of the Mobius transformation function, and is substituted into the Mobius transformation function to obtain a left encoded value $f(x2)$.

S203: the encoding interval corresponding to the to-be-encoded child node is determined based on the left encoded value and the right encoded value.

As shown in the above example, it can be learned from the formula (3) that $f(x1)$ and $f(x2)$ are two rational numbers within the encoding interval $[\frac{lft\_num}{lft\_den}, \frac{rgt\_num}{rgt\_den}]$. Accordingly, [$f$($x$1), $f$($x$2)] serves as the encoding interval of the child node, so that the encoding interval of the child node can be nested in the encoding interval $[\frac{lft\_num}{lft\_den}, \frac{rgt\_num}{rgt\_den}]$ of the parent node, to construct the encoding interval of the parent-child node with a hierarchical relationship.

Further, for different to-be-encoded child nodes, encoding intervals of a plurality of independent child nodes can be obtained by setting different node indexes. Exemplarily, the first child node corresponds to the node indexes $x$1 and $x$2, the second child node corresponds to the node indexes $x$2 and $x$3, the third child node corresponds to the node indexes $x$3 and $x$4, and so on.

In an embodiment, an optional mode of adjusting endpoint values of a parent interval corresponding to a parent node of a to-be-encoded child node is provided, that is, a mode of detailing the S203. A specific implementation process may include: endpoint values of a parent interval corresponding to the parent node of the to-be-encoded child node are adjusted based on a scaling factor, and coefficient values of the Mobius transformation function are obtained.

When the endpoint values $[\frac{lft\_num}{lft\_den}, \frac{rgt\_num}{rgt\_den}]$ of the parent interval corresponding to the parent node, are not reduced fractions, an interval scaling factor can be extracted to adjust the endpoint values of the parent interval corresponding to the parent node. It is assumed that interval scaling factors of left and right values are respectively $\lambda$ and $\mu$, the scaling factors are substituted into the above formula (3), and the following formula (4) is obtained:

$$\frac{\lambda*lft\_num}{\lambda*lft\_den} \le f(x;\lambda,\mu) = \frac{\lambda*lft\_num*x+(\mu*rgt\_num-\lambda*lft\_num)}{\lambda*lft\_den*x+(\mu*rgt\_den-\lambda*lft\_den)} \le \frac{\mu*rgt\_num}{\mu*rgt\_den} \qquad (4)$$

In this case, $f(x)$ is referred to as a nested interval generator, $f(x; \lambda, \mu)$ is referred to as a nested interval generator with scaling factors. Correspondingly, Mobius mapping functions $a, b, c,$ and $d$ are respectively expressed as follows:

$$a= \lambda *lft\_num;$$

$$b= \mu *rgt\_num- \mu *lft\_num;$$

$$c= \lambda *lft\_den;$$

$$d=\mu*rgt\_num-\lambda*lft\_den.$$

In the embodiment, by setting the scaling factors, endpoint values of an initial parent interval can be adjusted to construct a novel Mobius mapping function, so that encoding intervals of different to-be-encoded child nodes are generated, thereby implementing a flexible division of the encoding intervals.

Further, in order to further improve the diversity of the generated encoding intervals of the to-be-encoded child nodes, as shown in FIG. 3, the embodiment provides an optional mode of determining a node index as a variable value of the Mobius transformation function, that is, a manner of detailing the S203.

S301: the node indexes are transformed based on an encoding type selection function, and transformed indexes are obtained.

The encoding type selection function is a monotone function $g(x)$ of the node indexes in the parent interval, and $g(x)$ satisfies the following condition: (1) g(0) = 1 or $g(1) = 1$, and $\lim_{x\to\infty} g(x) = \infty$; (2) $g(x)$ is monotone when $x \in [1, +\infty]$.

Optionally, the encoding type selection function is a linear function or an exponential function.

S302: the transformed indexes are determined as variable values of the Mobius transformation function.

As shown in the above example, $x$1 is substituted into $g(x)$ to obtain a transformed index $g(x1)$, $x$2 is substituted into $g(x)$ to obtain a transformed index $g(x2)$, $g(x1)$ and $g(x2)$ are determined as variable values of the Mobius transformation function.

Specifically, based on the formula (4), $g(x)$ is introduced to obtain a novel composite nested interval generator, that is, the following formula (5):

$$M(x;\lambda,\mu) = (f(g)(x;\lambda,\mu)) = \frac{\lambda^* lft\_num^* g(x) + (\mu^* rgt\_num - \lambda * lft\_num)}{\lambda^* lft\_den^* g(x) + (\mu^* rgt\_den - \lambda^* lft\_den)} \qquad (5)$$

In this case, $M(x1, \lambda, \mu)$ and $M(x2, \lambda, \mu)$ are determined as encoding intervals of the to-be-encoded child node.

In the embodiment, by introducing the encoding type selection function $g(x)$, the node indexes of the to-be-encoded node can be transformed to obtain the transformed indexes, and then the transformed indexes are substituted into the Mobius mapping function to obtain different encoding intervals, so that the generated encoding intervals are diversified.

In an embodiment, the encoding method may further include: for any encoding interval, a mapping relationship between the encoding interval and a parent interval corresponding to the encoding interval is determined and stored.

The mapping relationship is configured to, when a query instruction corresponding to the parent interval is acquired, determine the parent interval corresponding to the encoding interval according to the encoding interval.

Specifically, a child node can be queried through a partial order query. When a parent node is queried, the encoding of the parent node can be obtained by using the following method.

As an example, it is assumed that an encoding interval is $\left[ \frac{lft\_num}{lft\_den}, \frac{rgt\_num}{rgt\_den} \right]$, where lft_num represents a left-value numerator, lft_den represents a left-value denominator, rgt_num represents a right-value numerator, rgt_den represents a right-value denominator. index represents a node index of any child node, and a parent interval (upper-level) corresponding to the encoding interval is $\left[ \frac{b}{a}, \frac{d}{c} \right]$.

Specifically, the mapping relationship between the encoding interval and the parent interval corresponding to the encoding interval is as follows:

$$resNum = lftNum - rgtNum$$

$$resDen = lftDen - rgtDen$$

$$a = resDen/(g(index) - g(index-1))$$

$$b = lftDen - a*g(index)$$

$$c = resNum/(g(index - g(index-1)))$$

$$d = leftNum - c*g(index)$$

As an example, based on the above embodiments, in this embodiment, an optional encoding method is provided, and the specific implementation process may include following steps.

Step 1: the interval scaling factors $\lambda$ and $\mu$ for the component tree encoding are set. In order to ensure that the obtained encoded node of the device tree is a reduced fraction, generally it is set that $\lambda=1$ and $\mu=1$.

Step 2: a nuclear power equipment body is selected as a parent node, and a nested interval encoding thereof is set as $\left[ \frac{lft\_num}{lft\_den}, \frac{rgt\_num}{rgt\_den} \right]$. In the configuration tree structure of the nuclear power equipment, it is set that lft_num=0, lft_den=1, rgt_num=1, and rgt_den=1, that is, an initial interval is set as $\left[ \frac{0}{1}, \frac{1}{1} \right]$.

Step 3: an encoding type selector $g(x)$ in compliance with specifications is set, for example, $g(x) = x$.

Step 4: a composite nested interval generator $M(x, \lambda, \mu)$ with scaling factors is obtained according to the parameters in step 1 to step 3.

Step 5: the node index $i$ of the to-be-encoded child node is substituted into the composite nested interval generator to generate nested interval encoding $M(i + 1, \lambda, \mu)$ and $M(i, \lambda, \mu)$ of the child node.

Step 6: the nested interval encoding $(i + 1, \lambda, \mu)$ and $M(i, \lambda, \mu)$ of the to-be-encoded child node serve as the initial intervals, and step 1 to step 5 are repeated to generate the nested interval encoding of a grandchild node.

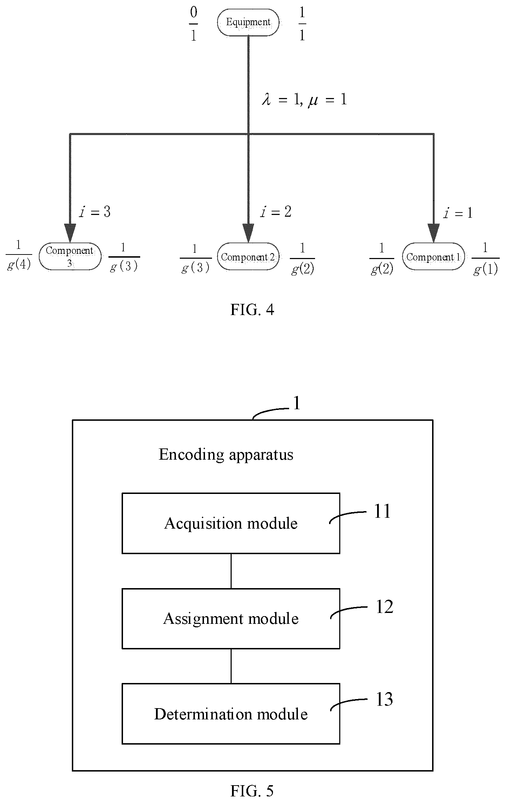

As shown in FIG. 4, it shows a schematic diagram of device tree encoding based on a nested interval model. The nested interval encoding of a device body is $\left[\frac{0}{1}, \frac{1}{1}\right]$, and the interval scaling factors $\lambda$ and $\mu$ for the device tree encoding are both set as 1. By using the above step 1 to step 6, the entire device tree can be encoded.

It should be appreciated that, although steps in the flow charts related to the above embodiments are sequentially displayed in an order indicated by arrows, these steps are not definitely performed in sequence indicated by the arrows. Unless expressly stated in the description, these steps are not performed in a strict order, and these steps may be performed in other orders. In addition, at least a part of steps in the flow charts involved in the above embodiments may include multiple steps or multiple phases. These steps or phases are not definitely performed at a same moment, but may be performed at different moments. These steps or phases are not definitely performed sequentially, but may be performed in turns or alternately with other steps or at least a part of steps or phases in other steps.

Based on the same invention concept, in an embodiment of the present invention, an encoding apparatus for implementing the aforementioned encoding method is provided. The implementation solution provided by the apparatus is similar to the implementation solution described in the aforementioned method. Therefore, for specific limitations in one or more embodiments of the encoding apparatus provided below, reference can be made to the limitations on the encoding method above, and the details are not repeated herein.

In an embodiment, as shown in FIG. 5, an encoding apparatus 1 is provided, which may include an acquisition module 11, an assignment module 12, and a determination module 13.

The acquisition module 11 is configured to acquire a node index corresponding to a to-be-encoded child node.

The assignment module 12 is configured to determine the node index as a variable value of the Mobius transformation function.

The determination module 13 is configured to obtain an encoding interval corresponding to the to-be-encoded child node based on coefficient values of the Mobius transformation function and the variable value corresponding to the node index. The coefficient values of the Mobius transformation function are obtained by adjusting endpoint values of a parent interval corresponding to a parent node of the to-be-encoded child node.

In an embodiment, the determination module 13 is further configured to adjust the endpoint values of the parent interval corresponding to the parent node of the to-be-encoded child node based on scaling factors, and obtain the coefficient values of the Mobius transformation function.

In an embodiment, the assignment module 12 is further configured to: transform the node index based on an encoding type selection function to obtain a transformed index, and determine the transformed index as the variable value of the Mobius transformation function. The encoding type selection function is a monotone function of node indexes in the parent interval.

In an embodiment, the encoding type selection function is a linear function or an exponential function.

In an embodiment, the node index includes a left sub-index and a right sub-index. The determination module 13 is further configured to: determine a left encoded value based on the left sub-index and the coefficient values of the Mobius transformation function; determine a right encoded value based on the right sub-index and the coefficient values of the Mobius transformation function; and determine the encoding interval corresponding to the to-be-encoded child node based on the left encoded value and the right encoded value.

In an embodiment, the encoding apparatus may further include a query module configured to, for an encoding interval, determine and store a mapping relationship between the encoding interval and a parent interval corresponding to the encoding interval. The mapping relationship is configured to, when a query instruction corresponding to the parent interval is acquired, determine the parent interval corresponding to the encoding interval according to the encoding interval.

All or a part of the modules in the above encoding apparatus may be implemented by using software, hardware, and a combination thereof. The above-mentioned modules may be embedded in or independent of a processor of a computer device in a hardware form, or may be stored in a memory of the computer device in a software form, so that the processor can invoke and execute operations corresponding to the above-mentioned modules.

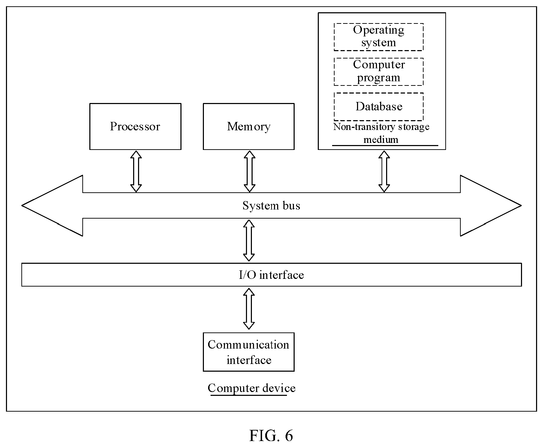

In an embodiment, a computer device is provided. The computer device may be a server, and an internal structure diagram of the computer device may be as shown in FIG. 6. The computer device may include a processor, a memory, and a network interface connected to each other through a system bus. The processor of the computer device is configured to provide computing and control capability. The memory of the computer device may include a non-transitory storage medium and an internal memory. The non-transitory storage medium stores an operating system, a computer program, and a database. The internal memory provides an environment for running the operating system and the computer program in the non-transitory storage medium. The database of the computer device is configured to store data of the encoding method. The network interface of the computer device is configured to communicate with an external terminal through a network connection. The computer program, when executed by the processor, may cause the processor to implement an encoding method.

A person skilled in the art may understand that the structure shown in FIG. 6 is merely a block diagram of partial structure related to the solution of the present application, and does not constitute a limitation on a computer device to which the solution of the present application is applied. A specific computer device may include more or fewer components than those shown in the figure, or combine some components, or have different component arrangements.

In an embodiment, a computer device is provided, which may include a processor and a memory storing a computer program. The processor, when executing the computer program, may be configured to:

acquire a node index corresponding to a to-be-encoded child node;

determine the node index as a variable value of a Mobius transformation function; and

obtain an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

In an embodiment, when executing the computer program to adjust the endpoint values of the parent interval corresponding to the parent node of the to-be-encoded child node, the processor may be specifically configured to: adjust the endpoint values of the parent interval corresponding to the parent node of the to-be-encoded child node based on scaling factors, and obtain the coefficient values of the Mobius transformation function.

In an embodiment, when executing the computer program to determine the node index as the variable value of the Mobius transformation function, the processor may be specifically configured to: transform the node index based on an encoding type selection function to obtain a transformed index, and determine the transformed index as the variable value of the Mobius transformation function. The encoding type selection function is a monotone function of node indexes in the parent interval.

In an embodiment, the encoding type selection function is a linear function or an exponential function.

In an embodiment, the node index may include a left sub-index and a right sub-index. When executing the computer program to obtain the encoding interval corresponding to the to-be-encoded child node based on the coefficient values of the Mobius transformation function and the variable value corresponding to the node index, the processor may be specifically configured to: determine a left encoded value based on the left sub-index and the coefficient values of the Mobius transformation function; determine a right encoded value based on the right sub-index and the coefficient values of the Mobius transformation function; and determine the encoding interval corresponding to the to-be-encoded child node based on the left encoded value and the right encoded value.

In an embodiment, the processor, when executing the computer program, may be further configured to: for an encoding interval, determine and store a mapping relationship between the encoding interval and a parent interval corresponding to the encoding interval. The mapping relationship is configured to, when a query instruction corresponding to the parent interval is acquired, determine the parent interval corresponding to the encoding interval according to the encoding interval.

In an embodiment, a computer-readable storage medium is provided, on which a computer program is stored. The computer program, when executed by a processor, may cause the processor to implement the following steps of:

acquiring a node index corresponding to a to-be-encoded child node;

determining the node index as a variable value of a Mobius transformation function; and

obtaining an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

In an embodiment, when executing the computer program to adjust the endpoint values of the parent interval corresponding to the parent node of the to-be-encoded child node, the processor may be specifically configured to: adjust the endpoint values of the parent interval corresponding to the parent node of the to-be-encoded child node based on scaling factors, and obtain the coefficient values of the Mobius transformation function.

In an embodiment, when executing the computer program to determine the node index as the variable value of the Mobius transformation function, the processor may be specifically configured to: transform the node index based on an encoding type selection function to obtain a transformed index, and determine the transformed index as the variable value of the Mobius transformation function. The encoding type selection function is a monotone function of node indexes in the parent interval.

In an embodiment, the encoding type selection function is a linear function or an exponential function.

In an embodiment, the node index may include a left sub-index and a right sub-index. When executing the computer program to obtain the encoding interval corresponding to the to-be-encoded child node based on the coefficient values of the Mobius transformation function and the variable value corresponding to the node index, the processor may be specifically configured to: determine a left encoded value based on the left sub-index and the coefficient values of the Mobius transformation function; determine a right encoded value based on the right sub-index and the coefficient values of the Mobius transformation function; and determine the encoding interval corresponding to the to-be-encoded child node based on the left encoded value and the right encoded value.

In an embodiment, the processor, when executing the computer program, may be further configured to: for an encoding interval, determine and store a mapping relationship between the encoding interval and a parent interval corresponding to the encoding interval. The mapping relationship is configured to, when a query instruction corresponding to the parent interval is acquired, determine the parent interval corresponding to the encoding interval according to the encoding interval.

In an embodiment, a computer program product is provided, which may include a computer program. The computer program, when executed by a processor, may cause the processor to implement the following steps of:

acquiring a node index corresponding to a to-be-encoded child node;
determining the node index as a variable value of a Mobius transformation function; and
obtaining an encoding interval corresponding to the to-be-encoded child node based on coefficient values of the Mobius transformation function and the variable value corresponding to the node index, in which the coefficient values of the Mobius transformation function are obtained by adjusting endpoint values of a parent interval corresponding to a parent node of the to-be-encoded child node.

In an embodiment, when executing the computer program to adjust the endpoint values of the parent interval corresponding to the parent node of the to-be-encoded child node, the processor may be specifically configured to: adjust the endpoint values of the parent interval corresponding to the parent node of the to-be-encoded child node based on scaling factors, and obtain the coefficient values of the Mobius transformation function.

In an embodiment, when executing the computer program to determine the node index as the variable value of the Mobius transformation function, the processor may be specifically configured to: transform the node index based on an encoding type selection function to obtain a transformed index, and determine the transformed index as the variable value of the Mobius transformation function. The encoding type selection function is a monotone function of node indexes in the parent interval.

In an embodiment, the encoding type selection function is a linear function or an exponential function.

In an embodiment, the node index may include a left sub-index and a right sub-index. When executing the computer program to obtain the encoding interval corresponding to the to-be-encoded child node based on the coefficient values of the Mobius transformation function and the variable value corresponding to the node index, the processor may be specifically configured to: determine a left encoded value based on the left sub-index and the coefficient values of the Mobius transformation function; determine a right encoded value based on the right sub-index and the coefficient values of the Mobius transformation function; and determine the encoding interval corresponding to the to-be-encoded child node based on the left encoded value and the right encoded value.

In an embodiment, the processor, when executing the computer program, may be further configured to: for an encoding interval, determine and store a mapping relationship between the encoding interval and a parent interval corresponding to the encoding interval. The mapping relationship is configured to, when a query instruction corresponding to the parent interval is acquired, determine the parent interval corresponding to the encoding interval according to the encoding interval.

A person of ordinary skill in the art should understand that all or part of the processes in the above-mentioned method embodiments can be implemented by instructing related hardware through a computer program. The computer program can be stored in a non-transitory computer-readable storage medium. When the computer program is executed, the processes of the above-mentioned method embodiments are included. Any reference to a memory, a database, or other medium used in the embodiments provided in the present application may include at least one of a non-transitory memory and a transitory memory. The non-transitory memory may include a read-only memory (ROM), a magnetic tape, a floppy disk, a flash memory, an optical storage, a high-density embedded non-volatile memory, a resistive random access memory (ReRAM), a magnetoresistive random access memory (MRAM), a ferroelectric random access memory (FRAM), a phase change memory (PCM), a graphene memory, etc. The transitory memory may include a random access memory (RAM) or an external cache memory, etc. By way of illustration and not limitation, the RAM may be in various forms, such as a static random access memory (SRAM) or a dynamic random access memory (DRAM). The database involved in each embodiment provided in the present invention may include at least one of a relational database and a non-relational database. The non-relational database may include, but is not limited to, a distributed database based on blockchain. The processor involved in each embodiment provided in the present invention may be a general-purpose processor, a central processing unit, a graphics processor, a digital signal processor, a programmable logic unit, a data processing logic unit based on quantum computing, etc., which is not limited thereto.

The technical features in the above embodiments can be arbitrarily combined. In order to make the description concise, all possible combinations of the technical features in the above embodiments are not described. However, as long as there is no contradiction in the combinations of these technical features, these combinations should be regarded as falling within the scope of the present invention.

The above-described embodiments merely express several implementation modes of the present application, and the description thereof is relatively specific and detailed, but it should not be construed as limiting the scope of the present application. It should be pointed out that, those skilled in the art can make several modifications and improvements without departing from the concept of the present application, which all fall within the scope of protection of the present application. Therefore, the protection scope of the present application should be subject to the appended claims.

## Claims

1.  An encoding method, comprising:

    acquiring a node index corresponding to a to-be-encoded child node;
    determining the node index as a variable value of a Mobius transformation function; and
    obtaining an encoding interval corresponding to the to-be-encoded child node based on coefficient values of the Mobius transformation function and the variable value corresponding to the node index, wherein the coefficient values of the Mobius transformation function are obtained by adjusting endpoint values of a parent interval corresponding to a parent node of the to-be-encoded child node.

2.  The method according to claim 1, wherein the adjusting the endpoint values of the parent interval corresponding to the parent node of the to-be-encoded child node comprises:
    adjusting the endpoint values of the parent interval corresponding to the parent node of the to-be-encoded child node based on scaling factors, and obtaining the coefficient values of the Mobius transformation function.

3.  The method according to claim 1, wherein the determining the node index as the variable value of the Mobius transformation function comprises:

    transforming the node index based on an encoding type selection function to obtain a transformed index, wherein the encoding type selection function is a monotone function of node indexes in the parent interval; and
    determining the transformed index as the variable value of the Mobius transformation function.

4.  The method according to claim 3, wherein the encoding type selection function is a linear function or an exponential function.

5.  The method according to claim 1, wherein the node index comprises a left sub-index and a right sub-index, and the obtaining the encoding interval corresponding to the to-be-encoded child node based on the coefficient values of the Mobius transformation function and the variable value corresponding to the node index comprises:

    determining a left encoded value based on the left sub-index and the coefficient values of the Mobius transformation function;
    determining a right encoded value based on the right sub-index and the coefficient values of the Mobius transformation function; and
    determining the encoding interval corresponding to the to-be-encoded child node based on the left encoded value and the right encoded value.

6.  The method according to claim 1, further comprising:

    for an encoding interval, determining and storing a mapping relationship between the encoding interval and a parent interval corresponding to the encoding interval;
    wherein the mapping relationship is configured to, when a query instruction corresponding to the parent interval is acquired, determine the parent interval corresponding to the encoding interval according to the encoding interval.

7. An encoding apparatus, comprising:

an acquisition module, configured to acquire a node index corresponding to a to-be-encoded child node;
an assignment module, configured to determine the node index as a variable value of the Mobius transformation function; and
a determination module, configured to obtain an encoding interval corresponding to the to-be-encoded child node based on coefficient values of the Mobius transformation function and the variable value corresponding to the node index, wherein the coefficient values of the Mobius transformation function are obtained by adjusting endpoint values of a parent interval corresponding to a parent node of the to-be-encoded child node.

8. A computer device, comprising a processor and a memory storing a computer program, wherein the processor, when executing the computer program, implements the method of any one of claims 1 to 6.

9. A computer-readable storage medium, on which a computer program is stored, wherein the computer program, when executed by a processor, causes the processor to implement the method of any one of claims 1 to 6.

10. A computer program product, comprising a computer program, wherein the computer program, when executed by a processor, causes the processor to implement the method of any one of claims 1 to 6.

a node index corresponding to a to-be-encoded child node is acquired — S101

the node index is determined as a variable value of the Mobius transformation function — S102

an encoding interval corresponding to the to-be-encoded child node is obtained based on the coefficient values of the Mobius transformation function and the variable value corresponding to the node index — S103

FIG. 1

a left encoded value is determined based on the left sub-index and the coefficient values of the Mobius transformation function — S201

a right encoded value is determined based on the right sub-index and the coefficient values of the Mobius transformation function — S202

the encoding interval corresponding to the to-be-encoded child node is determined based on the left encoded value and the right encoded value — S203

FIG. 2

the node indexes are transformed based on an encoding type selection function, and transformed indexes are obtained — S301

the transformed indexes are determined as variable values of the Mobius transformation function — S302

FIG. 3

$$\frac{0}{1} \quad \text{Equipment} \quad \frac{1}{1}$$

$$\lambda = 1, \mu = 1$$

$$i = 3 \qquad\qquad i = 2 \qquad\qquad i = 1$$

$$\frac{1}{g(4)} \;\; \text{Component } 3 \;\; \frac{1}{g(3)} \qquad \frac{1}{g(3)} \;\; \text{Component 2} \;\; \frac{1}{g(2)} \qquad \frac{1}{g(2)} \;\; \text{Component 1} \;\; \frac{1}{g(1)}$$

FIG. 4

1

Encoding apparatus

Acquisition module — 11

Assignment module — 12

Determination module — 13

FIG. 5

FIG. 6

## INTERNATIONAL SEARCH REPORT

| International application No. |
|---|
| **PCT/CN2023/114955** |

| | | |
|---|---|---|
| **A.** | **CLASSIFICATION OF SUBJECT MATTER** | |
| | G06F8/41(2018.01)i | |

According to International Patent Classification (IPC) or to both national classification and IPC

| **B.** | **FIELDS SEARCHED** |
|---|---|

Minimum documentation searched (classification system followed by classification symbols)

IPC: G06F

Documentation searched other than minimum documentation to the extent that such documents are included in the fields searched

Electronic data base consulted during the international search (name of data base and, where practicable, search terms used)

VEN, CNABS, CNTXT, WOTXT, USTXT, CNKI, IEEE: 编码, 节点, 莫比乌斯, 默比乌斯, 穆比乌斯, 父节点, 索引, encode, mobius, node, father node, index

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| PX | CN 116301899 A (CHINA NUCLEAR POWER ENGINEERING CO., LTD.; CHINA NUCLEAR POWER DESIGN CO., LTD. (SHENZHEN)) 23 June 2023 (2023-06-23) claims 1-10 | 1-10 |
| A | CN 107092659 A (CHENGDU YOUE DATA CO., LTD.) 25 August 2017 (2017-08-25) description, paragraphs 0025-0044 | 1-10 |
| A | CN 115145930 A (NANJING NORMAL UNIVERSITY) 04 October 2022 (2022-10-04) entire document | 1-10 |
| A | US 2013151565 A1 (XEROX CORP.) 13 June 2013 (2013-06-13) entire document | 1-10 |
| A | US 2021133246 A1 (BAIDU USA L.L.C.) 06 May 2021 (2021-05-06) entire document | 1-10 |
| A | Mohammad Gholami et al. "LDPC codes based on Mobius transformations" *The Institution of Engineering and Technology*, 16 May 2019 (2019-05-16), entire document | 1-10 |

| ☐ Further documents are listed in the continuation of Box C. | ☑ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 November 2023** | **14 November 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/114955**

| Patent document cited in search report | | | Publication date (day/month/year) | Patent family member(s) | | | Publication date (day/month/year) |
|---|---|---|---|---|---|---|---|
| CN | 116301899 | A | 23 June 2023 | None | | | |
| CN | 107092659 | A | 25 August 2017 | None | | | |
| CN | 115145930 | A | 04 October 2022 | None | | | |
| US | 2013151565 | A1 | 13 June 2013 | US | 8645428 | B2 | 04 February 2014 |
| US | 2021133246 | A1 | 06 May 2021 | CN | 112784115 | A | 11 May 2021 |

Form PCT/ISA/210 (patent family annex) (July 2022)

**EP 4 607 339 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310299035